# EUROPÄISCHE PATENTANMELDUNG

(11) **EP 0 906 966 A2**
(43) Veröffentlichungstag der Anmeldung: **07.04.1999**
(21) Anmeldenummer: 98116381.9
(22) Anmeldetag: 29.08.1998
(51) Int. Cl.: C23C 16/44

(54) **Verfahren zur CVD-Oberflächen-beschichtung und CVD-Reaktorsystem**

(30) Priorität: 04.10.1997 DE 19743922
(71) Anmelder: Verschleiss- Schutz-Technik Dr. Ing. Klaus Keller, D-79650 Schopfheim (DE)
(72) Erfinder: Keller, Klaus, Dr. Ing., CH-4612 Wangen (CH)
(74) Vertreter: Patentanwälte Westphal, Mussgnug & Partner

(57) **Zusammenfassung**

Die Erfindung bezieht sich auf ein Verfahren und ein Reaktorsystem zur CVD-Oberflächenbeschichtung. Bei diesem Verfahren wird das Reaktionsgas in beliebiger Frequenz und mit beliebigen Intervallen zeitlich nacheinander fallend und steigend in Form eines gepulsten Gasstromes in den Reaktorraum eingebracht.

Der Umkehrung der Gasströmungsrichtung dient ein innerhalb der Reaktor gelegenes Mehrwegeventil, das von außen mittels einer Stellwelle steuerbar ist.

## Beschreibung

Die Erfindung betrifft ein Verfahren zur CVD-Oberflächenbeschichtung sowie ein für dieses geeignetes CVD-Reaktorsystem.

Unter CVD-Beschichtung (Chemical Vapour Deposition) versteht man ein Verfahren, bei welchem gasförmige Stoffe mit den Oberflächen von anderen Materialien, z.B. Werkzeugen für die Metallverarbeitung, unter bestimmten Druck- und Temperaturverhältnissen zur chemischen Reaktion gebracht werden, so daß sich die in den Gasen enthaltenen Moleküle infolge thermischer Reaktionen auf der Oberfläche der anderen Materialien abscheiden und dort einen Überzug bilden.

Die CVD-Beschichtung gehört zum allgemeinen Stand der Technik.

Der Aufbau einer derartigen Beschichtungsanlage ist zum Beispiel von Hegi in der Zeitschrift "Metalloberfläche" 37 (1983), 4, Seite 166 bis Seite 168 beschrieben.

Bei derartigen Anlagen findet die Beschichtung der Werkstücke in einer Reaktorkammer hier bei steigendem Reaktionsgas statt. Bei dieser Beschichtungsanlage werden die Gase, so auch das Reaktionsgasgemisch, über ein Zentralrohr so eingeleitet, daß es im Reaktionsraum, d.h. im Bereich der Werkstücke, von unten nach oben aufsteigt, wobei die Prozeßabgase über ein oben gelegenes Abgasrohr abgesaugt und dann zur Abgasneutralisierungseinheit außerhalb der Reaktorkammer geleitet werden.

Auch bei der aus US 5,503,875 bekannten Anlage wird das Reaktionsgasgemisch, hier allerdings seitlich, so in den Reaktionsraum eingebracht, dass es von unten nach oben aufsteigt.

Daneben sind auch Anlagen bekannt, zum Beispiel aus US 5,441,570, bei welchen das Reaktionsgasgemisch von oben, also fallend, zugeführt wird.

Schließlich ist in DD 111 935 B1 eine Vorrichtung beschrieben, bei welcher das Reaktionsgasgemisch über ein Zentralrohr eingebracht wird, das über die Höhe verteilte Gasauslässe aufweist. Im Reaktionsraum strömt das Reaktionsgasgemisch stets radial von innen nach außen, also senkrecht zur Längsachse des Reaktionsraumes.

Die beispielhaft aufgeführten bekannten Varianten zeigen, daß bei CVD-Anlagen die Strömungsverhältnisse der gasförmigen Reaktanden für die Funktion wichtige Kriterien sind, da bei Einbringen des Reaktionsgasgemisches in den Reaktor die Konzentration an reaktionsfähigen Bestandteilen (z.B. TiCl4, CH4, N2 usw.) in Strömungsrichtung zwangsläufig kontinuierlich abnimmt. Das hat zur Folge, daß sich auch die Schichtbildungsbedingungen kontinuierlich verändern und z.B. die im Reaktor weiter von der Einspeisungsstelle entfernt angeordneten Werkstücke weniger stark oder gar nicht beschichtet werden. Ferner ändern sich auch die Haftungsbedingungen, die chemische Zusammensetzung, ggf. auch die Kristallausrichtung, die Topographie usw. und somit sinkt - oft allzu häufig - das applikationsrelevante Qualitätsniveau der Schichten rasch ab, insbesondere im von der Einspeisung entfernteren Bereich, d.h. im Bereich der Abgasstelle.

Das bedeutet aber, daß hierdurch die Baulänge bzw. die Bauhöhe der Reaktoren und damit der nutzbare Reaktionsraum allzu sehr begrenzt ist. So kann z. B. eine bei einer Beschichtungstemperatur von 1000°C entstehende, hoch korrosive Salzsäure HCl weiter entfernt von der Einspeisungsstelle die Werkstückoberflächen unzulässig stark anätzen, während im näheren Einspeisungsbereich die gewünschte Schichtbildung ordnungsgemäß stattfindet.

Da die Konzentrationsabnahme je nach Gasgemisch bzw. Schichttyp unterschiedlich ist, d.h. die Schichten unterschiedlich rasch aufwachsen, ergibt sich bei Mehrlagenschichten (z. B. TiC-TiCN-TiN, mitTiN als äußerste Deckschicht) unter bestimmten Umständen eine Schichtdickenverteilung, bei welcher auf den von der Gaseinspeisungsstelle entfernteren Werkstücken die gewünschte Mehrlagenschicht gar nicht existiert. Hier z. B. liegt vielmehr nur eine dünne (evtl. auch gar keine) TiN-Schicht auf einer angeätzten Werkstückoberfläche, die infolge der Ätzungen unzulässig aufgerauht ist. Solche Schichten sind qualitativ nicht zulässig, so daß so geschädigte Werkstücke ggf. verschrottet werden müssen.

Auch können durch zersetzungsbedingte Störgrößen ungünstige Stofftransfers in Strömungsrichtung stattfinden, welche mit wachsender Reaktionsraumgröße applikationsrelevante Probleme der Schichthaftung zur Folge haben.

Ein weiteres Problem bilden sogenannte Luv-Lee-Effekte, welche unterschiedliche Schichtdicken verursachen, je nachdem ob die zu beschichtende Fläche frontal angeströmt wird oder diese Fläche auf der der Anströmung abgekehrten Seite liegt.

Der Erfindung liegt die Aufgabe zugrunde, ein Verfahren und ein Reaktorsystem zur CVD-Oberflächenbeschichtung zu schaffen, bei welchen die oben erwähnten Nachteile vermieden, also die äußerst wichtige Vergleichmäßigung des Reaktionsverhaltens längs der Strömung zugunsten exakter Prozesssteuerung, Schichtqualität, Verbesserung der Multilayerschichten, der Prozessausbeute, Reaktorhochskalierung sowie Kostenreduktion erreicht wird.

Gelöst wird diese Aufgabe mit einem Verfahren nach Anspruch 1, bei welchem stets frisches Reaktionsgas in beliebiger Frequenz und mit beliebigen Intervallen zeitlich nacheinander fallend und steigend in Form eines gepulsten Gasstromes in den Reaktorraum eingebracht wird.

Beispielsweise kann das Reaktionsgas nach dem Prozessstart während der ersten Viertelstunde jeweils eine Minute steigend und jeweils eine halbe Minute fallend, im Anschluss daran mit anderen, beliebig einstellbaren Gasrichtungswechseldaten eingebracht werden. Dies hat einen gepulsten Gasstrom sowie zusätzlich eine günstige Gasverwirbelung und Gasdurchmischung zur Folge. Hierdurch lassen sich in großen Reaktionsräumen für alle zu beschichtenden Werkstücke bezüglich Struktur, Zusammensetzung, Schichtdicke und Schichttopographie - auch unter Eliminierung des Luv-Lee-Problems - sehr gleichmäßige Schichteigenschaften erzielen, wie sie sonst - selbst in kleinen Reaktoren - nicht erreichbar sind. Da damit die Abscheidungskinetik im gesamten Reaktionsraum auch weitgehend unabhängig von seiner Größe wesentlich besser beherrschbar und steuerbar ist, ergibt sich auch eine hervorragende Basis für Mehr- und Vielschichtsysteme sowie für die hoch aktuelle Multilayertechnik mit Submikrometer- bis hin zu Nanometerstrukturen. Dies wiederum ist besonders wichtig für die gleichmäßige, höchst zuverlässige Beschichtung großer bzw. langer Werkzeuge, insbesondere für die Beschichtung von Großwerkzeugen.

Das erfindungsgemäße Verfahren läßt sich mit herkömmlichen CVD-Anlagen aus folgenden Gründen nicht zufriedenstellend bzw. nicht im Dauerbetrieb realisieren, so dass mit der Erfindung gleichzeitig eine neue Gestaltung des CVD-Reaktorsystems gemäß Anspruch 2 vorgeschlagen wird.

Bei der CVD-Beschichtung haben die Reaktionsgase Temperaturen in einer Größenordnung von 900 bis 1000°C. Zur Umschaltung der Strömungsrichtung dieser Reaktionsgase im Reaktor selbst sind Umkehrventile höchster Hitzebeständigkeit notwendig. Zwar könnte eine Umschaltung der Strömungsrichtung mit Hilfe von außerhalb des beheizten Reaktorraumens montierten Ventilen erfolgen. Diese würden jedoch infolge der meist korrosiven Gasgemische schon nach kürzester Zeit undicht. Vor allem aber würden die Abgasventile sehr rasch verstopfen. Ursache für die Verstopfung ist vor allem der feste Niederschlag von Chloriden, Oxiden und Feststoffpartikeln, die sich bei Temperaturen unterhalb von 400 bis 500°C zu festen Krusten in den kühleren Abgassystemen niederschlagen.

Um dennoch die Gasströmung mit beliebig steuerbarer Richtungsumkehr zu realisieren, wird mit der Erfindung ein völlig neues Reaktionsgas-Umkehrsystem vorgeschlagen, das Gas-Umschaltungen nur geringfügig unterhalb der Reaktionstemperatur (bis 1100°C) in kürzesten Zeitabständen und mit beliebigen Intervallen dauerhaft funktionsfähig ermöglicht und deshalb wegen der äußerst korrosiven Zerfallsprodukte und Abgase nicht nur äußerst hitzebeständig, sondern vor allem extrem beständig gegen Heißkorrosion sein muß.

Ein derartiges System ist mit Anspruch 2 vorgeschlagen.

Voraussetzung ist hierbei, dass das der Gasumkehr dienende Element, nämlich ein Mehrwegeventil, aus thermischen Gründen innerhalb des Reaktorgehäuses möglichst nahe am Reaktionsraum angeordnet und in ein entsprechend aufgeheiztes Ventilgehäuse integriert ist, wobei sämtliche Bauelemente aus temperatur- und und korrosionsbeständigem Graphit bestehen. Nach einem weiteren Vorschlag erfolgt die Betätigung dieses innerhalb der Reaktorkammer gelegenen Ventils mittels einer von außen betätigbaren Stellwelle.

Konstruktive Ausgestaltungen des Mehrwegeventils nach Anspruch 2 sind mit den Ansprüchen 3 bis 6 angegeben.

Weitere Maßnahmen, insbesondere zur Gewährleistung der Betriebssicherheit, sind Gegenstand der Ansprüche 7 und 8 und beziehen sich auf eine für die Sicherheit des Reaktors verbesserte Abdichtung zwischen Reaktorboden und Reaktorgehäuse bzw. Überwachung des Dichtungssystems.

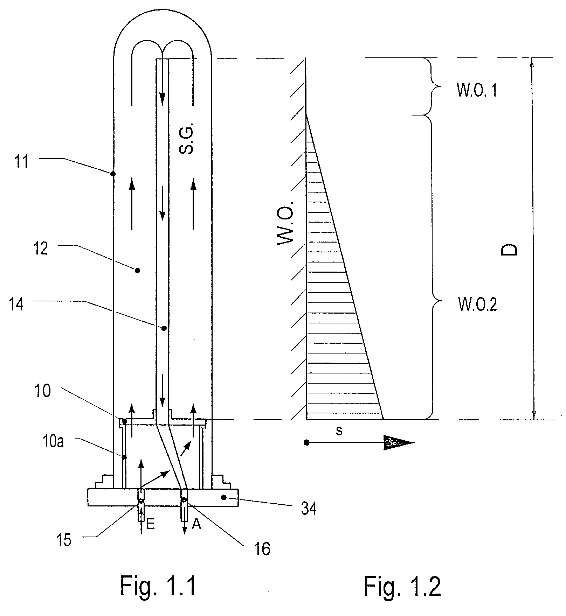

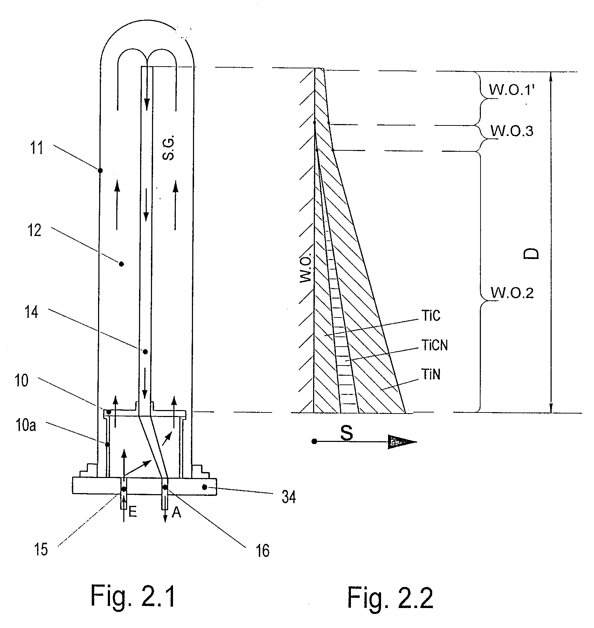

Im Übrigen sind die mit den erfindungsgemäßen Vorschlägen erzielbaren Vorteile sowie der Erfindungsgegenstand selbst anhand der nachstehend aufgeführten Zeichnungen im Einzelnen erläutert, wobei die Figuren 1 und 2 der Erläuterung des bekannten Standes der Technik dienen. In den Zeichnungen zeigen:
- Fig. 1.1 u. 2.1: Schematische Darstellung eines CVD-Reaktors, bei welchem das Reaktionsgas steigend eingebracht wird.
- Fig. 1.2: Diagramm zu Veranschaulichung der Schichtdickenverteilung in dem langgestreckten Reaktionsraum des Reaktors gem. Fig. 1.1.
- Fig. 2.2: Diagramm der Schichtdickenverteilung ähnlich dem Diagramm in Fig. 1.2, jedoch bei einer TiC-TiCN-TiN-Triplexschicht.
- Fig. 3.1: Schematische Darstellung eines erfindungsgemäß gestalteten CVD-Reaktors, in welchem während eines ersten Intervalls das Reaktionsgasgemisch fallend in die Reaktorkammer eingebracht wird.
- Fig.3.2: Diagramm zur Veranschaulichung der sich bei dem Beschichtungsvorgang gem. Fig. 3.1 ergebenden Schichtdickenverteilung.
- Fig.3.3: Schematische Darstellung des erfindungsgemäßen CVD-Reaktors gem. Fig. 3.1, bei welchem bei einem nachfolgenden Intervall das Reaktionsgasgemisch steigend eingebracht wird.
- Fig. 3.4: Diagramm der Schichtdickenverteilung, welche sich bei dem Beschichtungsvorgang gem. Fig. 3.3 ergibt.
- Fig. 3.5: Gesamte Schichtdickenverteilung nach den Beschichtungsvorgängen gem. Fig. 3.1 und 3.3 als Überlagerung der Schichtdickenverteilungen gem. Fig. 3.2 und 3.4.
- Fig. 4.1: Vergrößerter Axialschnitt des erfindungsgemäßen Reaktors gemäß Fig. 3.1 im Bereich des Mehrvegeventils bei fallendem Reaktionsgas.
- Fig. 4.2: Vergrößerter Axialschnitt entsprechend Fig. 3.3 und analog zum Schnitt in Fig. 4.1 bei steigendem Reaktionsgas.
- Fig. 5.1: Diagramm zur Veranschaulichung der Schichtdickenverteilung bei einer TiC-TiCN-TiN-Triplexbeschichtung mit steigendem Reaktionsgas, wie in Fig. 2.2.
- Fig. 5.2: Gesamte Schichtdickenverteilung im Kontrast zu Fig. 5.1 bei abwechselnd steigendem und fallendem Reaktionsgas in Analogie zu Fig. 3.5.
- Fig. 6.1: Sicht auf die Unterseite der Ventilscheibe.
- Fig. 6.2: Schnitt längs der Linie B-B in Fig. 6.1.
- Fig. 6.3: Sicht auf die Oberseite der Ventilscheibe.
- Fig. 6.4: Schnitt längs der Linie A-A in Fig. 6.1 und
- Fig. 7: Vergrößerte, teilweise geschnittene Seiten-Teilansicht des erfindungsgemäßen Reaktors im Bereich von Reaktorflansch und Reaktorboden.

In Fig. 1.1 ist ein herkömmlicher CVD-Reaktor schematisch allerdings ohne den den Reaktor umgebenden Haubenofen dargestellt.

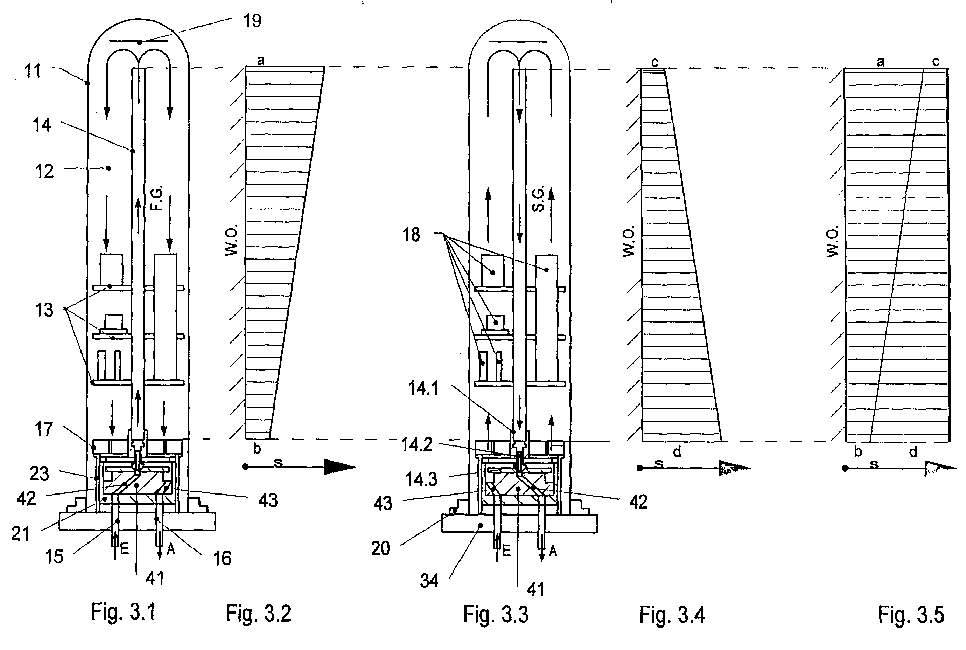

Dieser Reaktor besteht aus einem die Reaktorkammer 12 umschließenden Reaktorgehäuse 11, das an seinem oberen Ende kuppelartig und an seinem unteren Ende mittels des Reaktorbodens 34 abgeschlossen ist. Im Innern der Reaktorkammer 12 befindet sich ein Zentralgasrohr 14 zum Einleiten bzw. Abführen des Reaktionsgasgemisches. An diesem Zentralgasrohr 14 sind, wie in den Fig. 3.1 und 3.3 veranschaulicht, sternförmig ausgebildete Werkstückträger 13 vorgesehen, welche die zu beschichtenden Werkstücke 18 tragen.

Die Gaszufuhr E bzw. -abfuhr A erfolgt über die Einlass- und Auslassrohre 15 und 16, wie mit den Pfeilen angedeutet ist. Das Zentralgasrohr 14 wird von einer Basisplatte 10 mit einem Distanzrohr 10a getragen.

Wie mit den Pfeilen in Fig. 1.1 angedeutet, erfolgt hier die Oberflächenbeschichtung bei steigendem Gas S.G. Bei dieser Art der Einspeisung ergibt sich die in dem Diagramm gemäß Fig. 1.2 schematisch veranschaulichte Schichtdickenverteilung auf der Werkstückoberfläche W.O. Mit diesem Diagramm ist die Schichtdickenverteilung S auf den Werkstückoberflächen in Abhängigkeit von der Reaktionsdistanz D bzw. der Position der Werkstücke innerhalb einer nicht dargestellten Reaktorkammer 12 angedeutet.

Wie das Diagramm gem. Fig. 1.2 deutlich macht, werden die Werkstückoberflächen in dem mit W.O.1 bezeichneten Bereich ggf. einer zerstörenden Korrosionswirkung des Reaktionsgasgemisches ausgesetzt, so dass die Oberflächen der sich in diesem Bereich befindlichen Werkstücke nicht beschichtet, unter Umständen sogar stark angeätzt werden.

Mit den Darstellungen gem. Fig. 2.1 und 2.2 ist die Beschichtung der Werkstückoberfläche mit einer TiC-TiCN-TiN-Triplexschicht gleichfalls bei steigendem Gas S.G. veranschaulicht. Die Darstellung gem. Fig. 2.1 entspricht darum der Darstellung gem. Fig. 1.1.

Mit dem Diagramm gem. Fig. 2.2 ist entsprechend dem Diagramm in Fig. 1.2 die Schichtdickenverteilung der unterschiedlichen, übereinander gelagerten Schichten schematisch gezeigt. Wie im Falle gem. Fig. 1.2 wachsen auch hier die Schichten über der Reaktionsdistanz D unterschiedlich rasch, so dass sich, wie einleitend ausgeführt, auch bei einer Mehrlagenschicht eine ungleichmäßige Schichtdickenverteilung der einzelnen Schichten ergibt. Dabei erweist sich z. B., dass hier die TiN-Abscheidung über eine größere Reaktionsdistanz reicht und somit auch den von TiC und TiCN nicht beschichteten Bereich W.O.1' zu bedecken vermag, allerdings auf mehr oder weniger während der TiC- bzw. TiCN-Abscheidung angeätzter Oberfläche.

In dem Bereich W.O.3 bildet sich vor Abscheiden der TiN-Schicht eine dünne TiC-Schicht geringer Stärke, die aber eine zu starke Anätzung bereits verhindern kann. Nur in dem Bereich W.O.2' entsteht die vollständige Triplexschicht, jedoch gleichfalls mit von der Reaktionsdistanz D abhängige Dicke der einzelnen Schichtlagen.

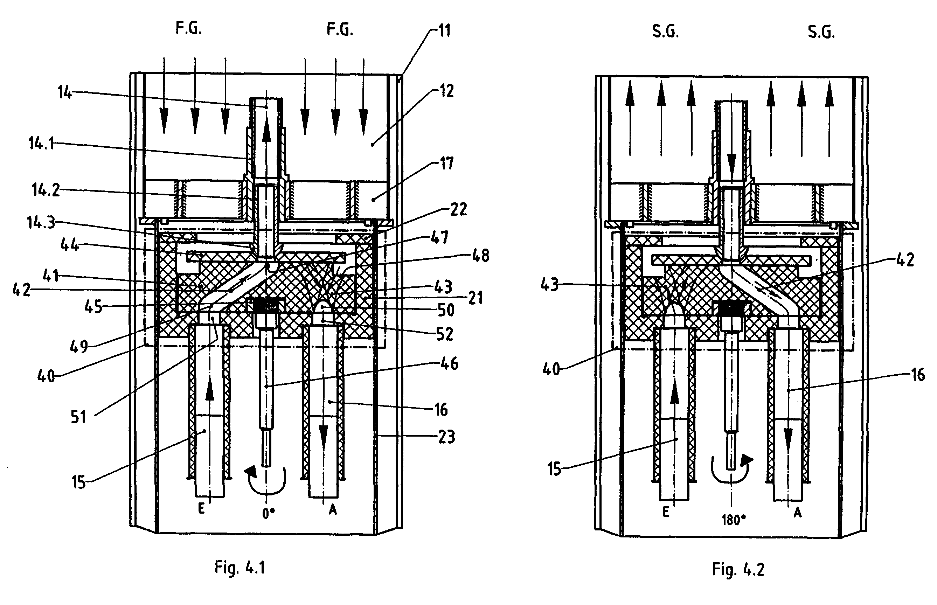

Mit dem erfindungsgemäß ausgebildeten Reaktor, wie er in den Fig. 3.1 und 3.3 schematisch veranschaulicht ist, ist auch bei großer Bauhöhe, also bei langen Strömungswegen bzw. Reaktionsdistanzen D, eine gleichmäßige Beschichtung möglich, wie nachstehend erläutert ist. Mittels eines mit der Erfindung vorgeschlagenen Mehrwegeventils oder Umkehrventils 40, dessen Aufbau und Funktionsweise nachstehend anhand der Fig. 4.1 und 4.2 noch erläutert werden, ist es möglich, die Strömungsrichtung des Reaktionsgasgemisches während des Beschichtungsprozesses zu ändern, so dass, wie bei der Anordnung gem. Fig. 3.1 zunächst fallendes Gas F.G. und anschließend, wie mit Fig. 3.3 veranschaulicht, steigendes Gas S.G. die Reaktorkammer 12 durchströmt.

Diese Art der Gasführung wirkt sich auf die Oberflächenbeschichtung der Werkstücke 18 aus. Diese befinden sich innerhalb der Reaktorkammer 12 auf aus wärmebeständigem Material bestehenden Werkstückträgern 13, die das Zentralgasrohr 14 umgeben, welches wiederum vom Basisträger 17 gehalten wird. Sowohl das Reaktorgehäuse 11 als auch das Zentralgasrohr 14 bestehen aus hochhitze- und korrosionsbeständiger Sonderlegierung.

Das Reaktionsgasgemisch wird bei E von außen über das den Reaktorboden 34 durchsetzende Einlassrohr 15 eingeleitet und dem Mehrwegeventil 40 (Fig. 1) zugeführt, das mittels des Trägerrohres 23 von dem Reaktorboden 34 getragen wird. Das über das Einlassrohr 15 eingeleitete Reaktionsgas gelangt bei der in Fig. 3.1 dargestellten Position über den Ventilkanal 42 der Ventilscheibe 41 in das Zentralgasrohr 14, wird nach oben befördert und oberhalb des Zentralgasrohrauslasses mittels der Prallscheibe 19 umgelenkt, so dass es als fallendes Gas F.G. in die Reaktorkammer 12 zur Beschichtung der Werkstücke 18 gelangt. Hierbei setzt das Gas durch heterogene Reaktionen an den auf den Werkstückträgern lagernden Werkstücken bzw. Werkzeugen 18 die zur Schichtbildung erforderlichen Spenderstoffe frei.

Auf dem weiteren Weg verarmt das Reaktionsgas an Spenderstoffreaktanden und reichert sich, wie bereits oben erläutert, mit Zersetzungsprodukten an. Das Gas wird schließlich als Abgas über den doppelarmigen Ventilkanal 43 der Ventilscheibe 41 abgesaugt und verläßt über das einzige Auslaßrohr 16, das gleichfalls den Reaktorboden 34 durchsetzt, den Reaktor. Bei diesem Verfahrensschritt ergibt sich die in Figur 3.2 schematisch veranschaulichte und bereits im Zusammenhang mit Figur 1.2 und 2.2 erläuterte Schichtdickenverteilung.

Bei dem in Figur 3.3 veranschaulichten Reaktor ist mittels des Mehrwegeventils 40 die Strömungsrichtung umgekehrt. Zu diesem Zweck ist lediglich die Ventilscheibe 41 von außen mittels der Stellwelle 46 um 180° zu drehen, ohne daß außerhalb des Reaktors irgendein Ventil betätigt werden müßte. Der genaue Aufbau und die Funktionsweise dieses Ventils sind nachstehend anhand der Figuren 4.1 und 4.2 erläutert.

Die Konstruktion und Anordnung dieses Mehrwegeventils 40 erfordert nur ein einziges Einlaßrohr 15 und ein einziges Auslaßrohr 16, d. h. insgesamt nur zwei Gas-Rohrdurchführungen. In der in Figur 4.2 dargestellten Position durchläuft das Reaktionsgas den doppelarmigen Ventilkanal 43, fächert sich nach der Ventilscheibe 41 infolge der Verteiler- und Ausgleichsscheibe 44 und des Abdeckringes 22 rotationssymmetrisch auf und gelangt nach Passieren des die gesamten oberen Reaktoreinbauten tragenden, offenen Basisträgers 17 in die Reaktionskammer 12. Das Reaktionsgas durchläuft die Reaktorkammer 12 als steigendes Frischgas S.G., wobei sich der im Zusammenhang mit Figur 3.1 erläuterte Abscheidungsprozeß längs der steigenden Strömung ergibt, bis schließlich das verbrauchte Reaktionsgas in das obere Ende des Zentralgasrohres 14 eintritt, durch dieses über die Verbindungsrohre 14.1 und 14.2 und den Ventilkanal 42 zum Auslaßrohr 16 gelangt und hier abgeführt wird.

Mit den Figuren 3.2 und 3.4 sind schematisch die Schichtdickenverteilungen längs des gesamten Reaktionsraumes für fallendes Reaktionsgas F.G. bzw. steigendes Reaktionsgas S.G. dargestellt, welche in etwa auch stellvertretend für andere, die Reaktionseffizienz und die Schichtqualität betreffende Kriterien sind.

Infolge steigender und fallender Gasströmungen in kurzen Perioden wird durch die zeitlich beliebig einstellbaren Ventilstellungen das Schichtwachstum so gesteuert, daß die intervallmäßig erfolgenden Abscheidungen "lamellenartig" additiv zu stoffspezifischen Laminaten aufwachsen mit einer über die gesamte Reaktionsdistanz recht gleichmäßigen Laminatdickenverteilung, wodurch schließlich ein entsprechend gleichmäßiges Polylaminat bzw. eine weitgehend gleichmäßige und homogen aufgebaute Viellagenschicht entsteht, wie dies mit Figur 3.1 für einzelne Laminate schematisch dargestellt ist.

Zunächst würde man folgern, daß für eine gleichmäßige Schichtdickenverteilung gemäß Figur 3.5 zeitgleiche Steuerintervalle benötigt werden. In der Praxis ist das aus vielerlei Gründen nicht der Fall, so daß sowohl die Schaltfrequenz als auch das jeweilige Schaltintervall sowie das Schaltverhältnis eine wichtige Rolle spielen. Als Ergebnis dieser Erfindung resultiert aufgrund des einfachen und zuverlässigen Konstruktionsprinzips eine hervorragende Anpassungsfähigkeit an die jeweiligen Reaktions-, Anlagen-, Werkstück-, Werkstoff- und Applikationserfordernisse. Dies gilt umso mehr, wenn Mehr- und Viellagenschichtsysteme abzuscheiden sind, und ganz besonders, wenn erneute Quantensprünge mit Polylaminaten erzielt werden sollen, bei welchen sich die einzelnen Laminate aus zahlreichen, nur wenige Nanometer dünnen Schichtlamellen zusammensetzen.

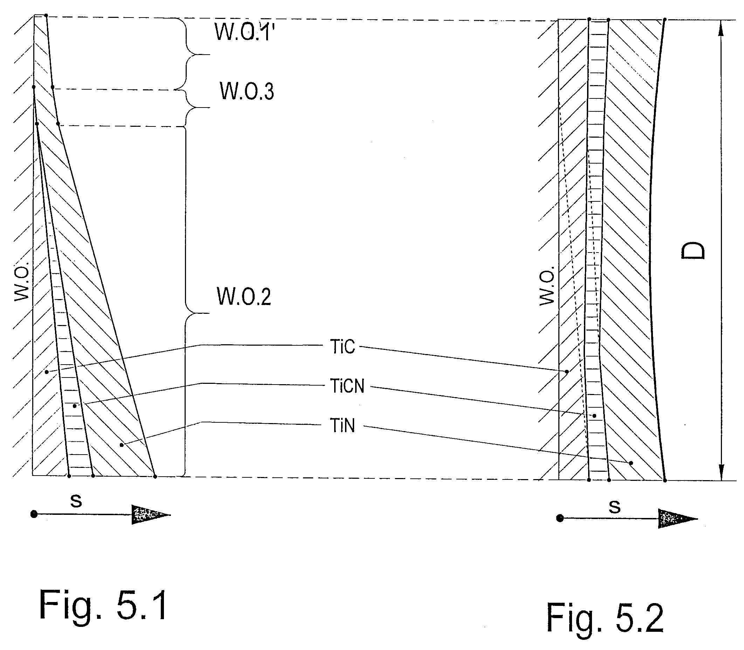

Die Vorteile der Erfindung fallen umso mehr ins Gewicht, je dünner die einzelnen Schichtlagen sein sollen. Dies sei anhand der Triplex-Schicht TiC-TiCN-TiN gemäß Figur 5.1 und 5.2 im Vergleich zu der bereits beschriebenen Schicht gemäß Figur 2.2 erläutert.

Angenommen wird eine recht lange Reaktionsdistanz D (z.B. D = 1,5 m), d. h., ein entsprechend großer Reaktor, wobei infolge nur einer Strömungsrichtung lediglich die unzulässige Schichtdickenverteilung gemäß Figur 2.2 erzielbar wäre, was auch in Figur 5.1 dargestellt ist. Durch die Richtungsumkehr ergibt sich (in der gleichen oder etwas kürzeren Beschichtungszeit) die in Figur 5.2 dargestellte Schichtdickenverteilung. (In diesem Beispiel wurde zur Verdeutlichung gewisser Variationsmöglichkeiten angenommen, daß die Ventilstellungen in den Prozeß-Phasen für die TiC- und TiCN-Schichtbildung zeitlich leicht asymmetrich eingestellt wurden, so daß das schrittweise Aufwachsen der einzelnen Lamellen im Rhythmus der Gasumkehrzyklen zum TiC- bzw. TiCN-Laminat geringfügig verschobene Schichtdickenprofile ergibt, die hier durch das nachträgliche lamellare Aufwachsen des TiN-Laminats allerdings abgeschwächt erscheinen.)

Aus diesen Darlegungen ist ersichtlich, daß die Realisierung einer periodischen Gasumkehr eine wesentliche Abscheidungsverbesserung bewirkt, derzufolge alle Bauteile eine eng definierbare Schichtdickentoleranzbreite (ca. 20 %) auf hohem Qualitätsniveau erfüllen und sogar die Wirksamkeit der Reaktionskinetik in gewissen Grenzen verschiebbar sind. Besondere Bedeutung erlangt - wie bereits erwähnt - diese herorragende Schichtgleichmäßigkeit bei der Abscheidung von Multilayersystemen. So lassen sich z.B. bei einer ca. 20%igen Schichtdickentoleranz auf 1,5 m Reaktionsdistanz durchaus noch 10 Laminate von durchschnittlich 1 Mikrometer Laminatdicke reproduzierbar abscheiden, ohne daß irgendwo das Fehlen eines Laminates, ja sogar nicht einmal das Fehlen deren einzelnen, noch wesentlich dünneren Lamellen zu befürchten wäre. Das erfindungsgemäß ausgebildete Mehrwegeventil 40 ist im

einzelnen detailliert in den Figuren 4.1 und 4.2 dargestellt.

Als Grundkörper dient das topfförmig ausgebildete Ventilgehäuse 21, in welchem eine Ventilscheibe 41 mit dem Einfach-Ventilkanal 42 und dem doppelarmigen Ventilkanal 43 drehbar geführt ist. Das topfartige Ventilgehäuse 21 ist in dem gerätefesten Trägerrohr 23 verdrehsicher fixiert. Das oben gelegene Ende bzw. die oben gelegene Öffnung 47 des Einfach-Ventilkanals 42 mündet über die teleskopartig wirkenden Verbindungsrohre 14.2 und 14.1 in das Zentral-Gasrohr 14. Das teleskopartig in das Verbindungsrohr 14.1 eingesetzte Verbindungsrohr 14.2 liegt mit dem halbkugelförmigen Drehkörper 14.3 auf einer mit der Ventilscheibe 41 verbundenen Verteiler- und Ausgleichsscheibe 44 dichtend auf. Die unten gelegenen Enden 49 und 50 der Ventilkanäle 42 und 43 münden in entsprechende Ein- und Auslaßöffnungen 51 und 52 des topfartigen Ventilgehäuses 21, an welches sich die einzigen Einlaß- und Auslaßrohre 15 und 16 anschließen. Die Ventilscheibe 41 läßt sich über den Mitnehmer 45 mittels einer Stellwelle 46 innerhalb des topfartigen Ventilgehäuses 21 derart verdrehen, daß alternativ das Zugas über den Einfachventilkanal 42 und das Zentralgasrohr 14 als fallendes Reaktionsgas F.G. in die Reaktorkammer 12 gelangt, wobei der doppelarmige Ventilkanal 43 die Verbindung der Reaktorkammer 12 zum Auslaßrohr freigibt. Für steigendes Reaktionsgas S.G. wird die Ventilscheibe 41 um 180° gedreht, wie Figur 4.2 erkennen läßt, wobei der doppelarmige Ventilkanal 43 das Frischgas direkt in die Reaktorkammer 12 fördert (steigendes Gas S.G.), während der Einlaßventilkanal 42 die Verbindung zum Abgasrohr 16 herstellt.

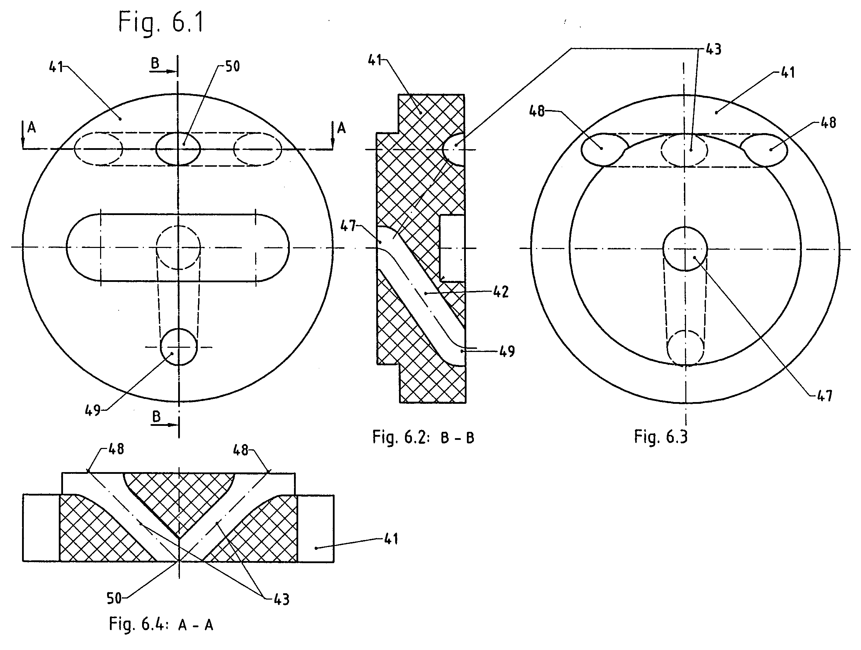

Einzelheiten der drehbaren Ventilscheibe 41 sind aus den Ansichten gemäß Fig. 6.1 und 6.3 sowie aus den Schnitten gemäß Figur 6.2 und 6.4 erkennbar.

Das erfindungsgemäße Beschichtungsverfahren ermöglicht, daß auch bei über 2,5 m Reaktionsdistanzen bisher nicht für realisierbar angesehene Schichtqualitäten erhalten werden, wodurch erst CVD-Großanlagen ermöglicht werden. Ein weiterer Vorteil des erfindungsgemäßen Verfahrens, nämlich des beliebig steuerbaren Gasumkehrprinzips, besteht darin, daß das Schichtwachstum über die gesamte Länge der Reaktorkammer um bis zu ca. 30% gesteigert wird und, je nach Prozeßführung, auch auf die Ausbildung tribologisch aktiver Topographien der äußersten Schichtoberfläche spezifisch Einfluß genommen werden kann.

Da das gesamte Ventilsystem, bestehend aus dem topfartigen Ventilgehäuse 21, dem Abdeckring 22, der Verteiler- und Ausgleichsscheibe 44, dem Verbindungsrohr 14.2 mit Drehkörper 14.3, der Stellwelle 46 und dem Mitnehmer 45, den heißen, oft halogenhaltigen Reaktionsgasen ausgesetzt ist, bestehen diese aus temperatur- und korrosionsbeständigem Graphit.

Die Stellwelle 46 ist in das Gehäuse über eine nicht dargestellte, gasdichte Drehdurchführung in den Reaktorinnenraum geführt und von außen betätigbar. Die Drehdurchführung weist eine flexible, armierte, vakuum- und überdruckfeste Dichtung auf, um Gasaus- und -eintritt sicher zu vermeiden.

Nach einem weiteren wichtigen Vorschlag der Erfindung ist der Reaktor gegenüber dem Arbeitsumfeld mit einem speziell auf dauerhafte Funktionszuverlässigkeit des Mehrwegeventils 40 abgestimmten Dichtsystems ausgerüstet. Dieses Abdichtsystem ist so ausgelegt, daß das Mehrwegeventil 40 trotz unmittelbarer Nähe zur Abdichtstelle zwischen Reaktorflansch 20 und Reaktorboden 34 bei (hoher) Prozeßtemperatur betrieben werden kann. Die hohe Betriebstemperatur des Mehrwegeventils 40 ist insofern erforderlich, als gewisse Abgasbestandteile bei Abkühlung kondensieren und zusammen mit den stets vorhandenen Reaktionsstaubpartikeln festhaftende Beläge bilden, die das Mehrwegeventil blockieren und in den Kanälen der Ventilscheibe 41 sowie im Ventilgehäuseauslaß 52 und Auslaßrohr 16 Verstopfungen verursachen können. Um also Fehlfunktionen des Mehrwegevetils 40 zu vermeiden, das Auslaßrohr also auch so kurz wie möglich zu halten, ist die Nähe von Mehrwegeventil 40 und Abdichtstelle zwingend vorgegeben. Um trotz der geringen Distanzen die Wämeübertragung auf die Dichtringe 26 ausreichend gering zu halten, ist ein besonders effizientes, mehrfach redundantes Dichtsystem erforderlich.

Da das durch das Einlaßrohr 15 nachströmende Frischgas durch Belagbildungen weniger behindert wird, kann sich bei Abgasstau im Reaktorgehäuse 11 ein Überdruck aufbauen, welcher bei einem einfach ausgelegten Dichtsystem die Gefahr des Austritts toxischer Gase in das Arbeitsumfeld zur Folge hätte.

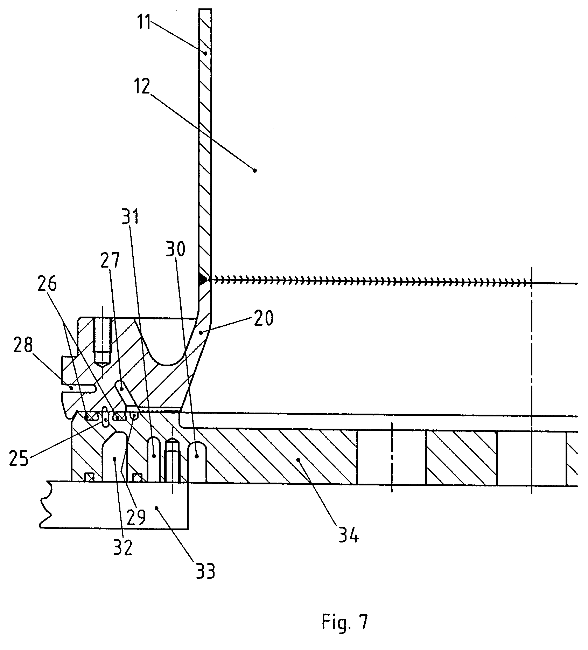

Einzelheiten dieses Dichtsystems zwischen Reaktorflansch 20 und Reaktorboden 34 sind in Figur 7 gezeigt. Zu dessen Realisierung sind in zwei konzentrischen Ringnuten des Reaktorbodens 34 temperaturbeständige O-Ringe 26 eingesetzt. Zwischen diesen beiden O-Ringen befindet sich zusätzlich ein ringförmiger Vakuumkanal 25, der zur Bildung eines Stützvakuums mit einer hier nicht gezeigten Vakuumpumpe verbunden ist.

Um eine übermäßige Erwärmung der Dichtringe 26 zu vermeiden, sind im Reaktorflansch 20 und im Reaktorboden 34 Ringkanäle 27 bis 31 zur Bildung von Wärmebarrieren eingeschnitten. Im äußeren Bereich sorgt ein wasserdurchströmter Kühlkanal 32 für die Wärmeabfuhr.

Durch die doppelte Dichtung mit den Dichtringen 26 wird ein hermetisch geschlossener Dichtkanal geschaffen, der mit dem erwähnten Stützvakuum beaufschlagt werden kann, welches über Drucksensoren bezüglich des Dichtungszustandes und des jeweils erforderlichen Unterdrucks permanent überwacht und je nach Situation variiert werden kann. Da der Druck im Stützvakuum stets unter dem Druck in der Reaktionskammer gehalten wird, kann weder Umgebungsluft in den Reaktionsraum eindringen, noch kann Reaktionsgas in das Arbeitsumfeld ausgasen. In beiden Fällen würden diese Leckströmungen über das Pumpsystem des Stützvakuums permanent abgesaugt. Aus diesem Grunde kann auch bei Abgasstau kein Reaktonsgas in das Arbeitsumfeld des Bedienungspersonals dringen, da die Gase nach etwaigem Passieren des inneren Dichtringes 26 über die Stützvakuumpumpe abgesaugt werden, noch bevor das Gas den äußeren Dichtring 26 passieren könnte. Doppeldichtung und Stützvakuumsystem sowie die wärmegedämmte Positionierung der Dichtringe 26 innerhalb der Wärmebarrieren 27 bis 31 sowie die Umlaufkühlung bedingen also einander zwangsläufig als sich selbst regelndes, untrennbares System, um etwaigen Funktionsstörungen des Mehrwegeventils 40 mit hoher Zuverlässigkeit vorzubeugen.

Damit repräsentiert diese Konstruktion ein in sich geschlossenes, redundantes Sicherheitskonzept, das erlaubt, die hier beschriebene Gasumkehrtechnik, insbesondere das Mehrwegeventil, nicht nur unter optimalen Betriebsbedingungen mit sehr hoher Prozeßsicherheit zu betreiben, sondern auch in äußerst kompakt arbeitenden Großanlagen unter schwierigsten Abscheidungsreaktionen ggf. auch mit toxischen Reaktanden dauerhaft zu beherrschen.

### Bezugszeichenliste

- 10: Basisplatte
- 10a: Distanzrohr
- 11: Reaktorgehäuse
- 12: Reaktorkammer
- 13: Werkstückträger
- 14: Zentralgasrohr
- 14.1: Verbindungsrohr
- 14.2: Verbindungsrohr
- 14.3: halbkugelförmiger Drehkörper
- 15: Einlaßrohr
- 16: Auslaßrohr
- 17: Basisträger
- 18: Werkstücke
- 19: Prallscheibe
- 20: Reaktorflansch
- 21: topfförmiges Ventilgehäuse
- 22: Abdeckring
- 23: Trägerrohr
- 24: Trägerring
- 25: Vakuumkanal
- 26: Dichtringe
- 27: Wärmebarriere
- 28: Wärmebarriere
- 29: Wärmebarriere
- 30: Wärmebarriere
- 31: Wärmebarriere
- 32: Kühlkanal
- 33: Reaktorbasisplatte
- 34: Reaktorboden
- 40: Mehrwegeventil
- 41: Ventilscheibe
- 42: Einfach-Ventilkanal
- 43: doppelarmiger Ventilkanal
- 44: Verteiler- und Ausgleichsscheibe
- 45: Mitnehmer
- 46: Stellwelle
- 47: oberes Ende des Einfach-Ventilkanals 42
- 48: obere Enden des doppelarmigen Ventilkanals 43
- 49: unteres Ende des Einfach-Ventilkanals 42
- 50: unteres Ende des doppelarmigen Ventilkanals 43
- 51: Ventilgehäuse-Einlaß
- 52: Ventilgehäuse-Auslaß
- E: Gaseinlaß
- A: Gasauslaß
- S.G.: steigendes Gas
- F.G.: fallendes Gas
- S.: Schichtdicke
- W.O.: Werkstückoberfläche
- W.O.1: unbeschichteter Bereich mit störender Korrosionseinwirkung
- W.O.1': unvollständig beschichteter Bereich auf W.O. mit Korrosionseinwirkung
- W.O.2: Bereich mit ungleichmäßiger Beschichtung
- W.O.3: teilbeschichteter Bereich
- D: Reaktionsdistanz

## Patentansprüche

1. Verfahren zur CVD-Oberflächenbeschichtung, bei welchem in einem Reaktorraum gasförmige Stoffe aus einem Reaktionsgas auf andere Materialien niedergeschlagen werden, dadurch gekennzeichnet, dass das Reaktionsgas in beliebiger Frequenz und mit beliebigen Intervallen zeitlich nacheinander fallend und steigend in Form eines gepulsten Gasstromes in den Reaktorraum eingebracht wird.

2. Vakuum- und überdruckbeständiges CVD-Reaktorsystem zur Durchführung des Verfahrens nach Anspruch 1 mit einer vertikalen Reaktorkammer und einem Zentralgasrohr zur Einleitung des Reaktionsgases in den Reaktorraum, welcher nach unten durch eine Basisplatte gasdicht abgeschlossen ist, durch welches Gaseinlass- und Auslassrohre geführt sind, wobei mit Hilfe einer Schaltvorrichtung die Gasströmungsrichtung umkehrbar ist, dadurch gekennzeichnet, dass zur Umkehrung der Gasströmungsrichtung ein Mehrwegeventil (40) innerhalb der Reaktorkammer (12) angeordnet und in die als topfförmiges Ventilgehäuse ausgebildete Basisplatte (21) integriert ist, wobei die Bauelemente des Mehrwegeventils (40), welche nicht wesentlich unter Prozeßtemperatur aufgeheizt werden, aus temperatur- und korrosionsbeständigem Graphit bestehen und das Mehrwegeventil (40) von außen mittels einer das Ventilgehäuse (21) abgedichtet durchsetzenden Stellwelle (46) zur Steuerung der Gasführung drehbar ist.

3. CVD-Reaktorsystem nach Anspruch 2, dadurch gekennzeichnet, dass das Mehrwegeventil (40) aus einer Ventilscheibe (41) besteht, welche innerhalb des topfförmig ausgebildeten Ventilgehäuses (21) angeordnet ist und zwei gegeneinander versetzte Ventilkanäle (42, 43) aufweist, welche je nach Drehstellung die Gaseinlassleitung (15) mit dem Zentralgasrohr (14) und die Reaktorkammer (12) mit der Gasauslassleitung (16) und umgekehrt verbinden.

4. CVD-Reaktorsystem nach Anspruch 3, dadurch gekennzeichnet, dass die Ventilscheibe (41) auf ihrer der Reaktorkammer (12) abgewandten Seite über einen zentrisch angeordneten Mitnehmer (45) mit einer von außen betätigbaren Stellwelle (46) verbunden ist, welche sich vorzugsweise zwischen den Einlaß- und Auslaßrohren (15, 16) befindet.

5. CVD-Reaktorsystem nach Anspruch 2, 3 oder 4, dadurch gekennzeichnet, daß einer der beiden Ventilkanäle (42, 43) in der Ventilscheibe (41) mit seinem einen Ende (42) mit dem Zentralgasrohr (14) und der andere Ventilkanal (43) mit mindestens einem Ende (48) mit der Reaktorkammer (12) verbunden ist, wobei die anderen Enden (49, 50) der Ventilkanäle (42, 43) derart positioniert sind, dass sie je nach Drehstellung der Ventilscheibe (41) alternativ mit der Zugas- bzw. Abgasleitung (15, 16) verbindbar sind.

6. CVD-Reaktorsystem nach Anspruch 5, dadurch gekennzeichnet, daß das der Ventilscheibe (41) zugewandte Ende des Zentralgasrohres (14) einenhalbkugelförmig, durchbohrten Drehkörper (14.3) aufweist, der dichtend und drehbar auf einer Verteiler- und Ausgleichsscheibe (44) der Ventilscheibe (41) aufsitzt.

7. CVD-Reaktorsystem nach einem der Ansprüche 2 bis 6, dadurch gekennzeichnet, daß das die Reaktorkammer (12) umschließende Reaktorgehäuse (11) an seinem oberen Ende kuppelartig verschlossen ist und an seinem unteren Ende einen Reaktorboden (30) aufweist, welcher mit einem Flansch (20) des Reaktorgehäuses (11) verbunden ist, wobei zwischen Flansch (20) des Reaktorbodens (30) ein temperaturbeständiges, redundantes Doppeldichtsystem, bestehend aus zwei konzentrischen Dichtringen (26) und einem dazwischen liegenden Vakuumkanal (25), vorgesehen ist.

8. CVD-Reaktorsystem nach Anspruch 7, dadurch gekennzeichnet, dass der Vakuumkanal (25) zur Bildung eines Stützvakuums und zur etwaigen Absaugung von Leckgasen unter Unterdruck steht und zusätzlich mit einem Leck-, Prüf- und Warnsystem verbunden ist.
